# EUROPEAN PATENT SPECIFICATION

(11) **EP 1 782 612 B1**
(45) Date of publication and mention of the grant of the patent: **01.10.2008**
(21) Application number: 05780560.8
(22) Date of filing: 05.08.2005
(51) Int. Cl.: H04M 3/22, G01R 31/02

(54) **CABLE VERIFICATION UNIT**
KABELVERIFIKATIONSEINHEIT
UNITE DE VERIFICATION DE CABLE

(30) Priority: 12.08.2004 ZA 200406384
(43) Date of publication of application: 09.05.2007
(73) Proprietor: Telkom SA Limited, 0002 Pretoria (ZA)
(72) Inventor: AMSENGA, Eltjo, 0157 Centurion (ZA); CARTWRIGHT, Eric David, 2194 Randburg (ZA); HIRSCH, Karl Heinz, 0042 Pretoria (ZA)
(74) Representative: Johnstone, Helen Margaret
(86) International application number: PCT/IB2005/002340
(87) International publication number: WO 2006/018691

(56) References cited:
- US-A- 5 107 532
- US-A- 5 627 474

## Description

### BACKGROUND OF THE INVENTION

This invention relates to a cable verification transceiver for tracing telephone cables that extend between a remote site and a local site.

It is often necessary for landline telephone network operators to verify and update cable network records, thereby allowing end-to-end cable routes to be compiled and/or verified. Typically, cable pairs between Street Distribution Cabinets (SDC's) and first Distribution Points (DP's) of the network need to be traced. Clearly, this needs to be done cost effectively, accurately, and with minimal human intervention.

At present, there are numerous ways in which this is achieved. A very crude way is to trace the individual pair by hand, but this is clearly a timeconsuming and clumsy way of achieving this, and is quite often impractical because telecommunications cables can extend for up to 5 kms. A further disadvantage of tracing by hand is that the cables can quite easily be damaged and/or disconnected from the equipment to which they are mounted by being pulled too hard.

The present invention aims to provide a cable verification transceiver that addresses the disadvantages mentioned above.

US patent No. 5,627,474 discloses a continuity tester for a plurality of electric conductors. For this purpose, a signal transmitter for admitting different individual identification signals to such conductors is connected to one of the ends of the conductors, whereby an identification is allocated to each signal transmitter connection. A signal receiver for decoding the different identification signals by means of a decoding device for indicating the allocated identification on a display is connected to the other ends of the conductors. The signal receiver has a sequence switchgear supplying the connected conductors individually and successively with a reference potential in a repeated cycle, whereby the decoding device for decoding the identification signal is formed at least on the one other conductor in each case. The signal transmitter has a signal generator generating for each of the signal transmitter connections the allocated identification signals multiple times, in a way such that no signal overlappings occur overall.

US 5,107,532 discloses a system for tracing a conductor connected between a terminal of one terminal block and a terminal of another terminal block within a network of conductors and terminal blocks. The system includes a supervisor associated with each terminal block for imposing a trace signal selectively on any of the terminals of said block. The supervisor also detecting a trace signal appearing on any of said terminals. A controller communicates with the supervisors to cause a selected supervisor to impose a trace signal on one of the terminal of its associated terminal block, and receives from the supervisors a report of another terminal at which the trace signal appears.

### SUMMARY OF THE INVENTION

According to the present invention there is provided a cable verification transceiver for tracing telecommunications cables that extend between a remote site and a local site so as to enable an end to end cable route to be determined, the transceiver having a transmit mode and a receive mode and further comprising:
a plurality of transmitters;
a plurality of receivers; and
a processor for, in the transmit mode, constructing a plurality of tracing signals that are each encoded with information regarding a cable pair into which the tracing signal is to be transmitted by one of the plurality of transmitters, and for, in the receive mode, decoding a plurality of incoming tracing signals received from a plurality of cables via the plurality of receivers so that the transceiver is connectable to either the remote site, in which case the transceiver is acting in the transmit mode, or the local site, in which case the transceiver is acting in the receive mode.

Typically, the telecommunications cable comprises at least one twisted copper pair.

The cable verification transceiver further includes a digital to analogue converter for use in the transmit mode, and an analogue to digital converter for use in the receive mode.

Advantageously, the cable verification transceiver further includes a first band pass filter for use in the transmit mode, and a second band pass filter for use in the receive mode.

Significantly, the tracing signal comprises a frame structure comprising a pair number field that takes the form of a numerical value that represents the pair number to which the transceiver is connected.

### BRIEF DESCRIPTION OF THE DRAWING

- **Figure 1**: shows a schematic block diagram of a cable verification unit ; and
- **Figure 2**: shows a block diagram of a transceiver according to the present invention used in the cable verification unit of figure 1.

### DESCRIPTION OF AN EMBODIMENT

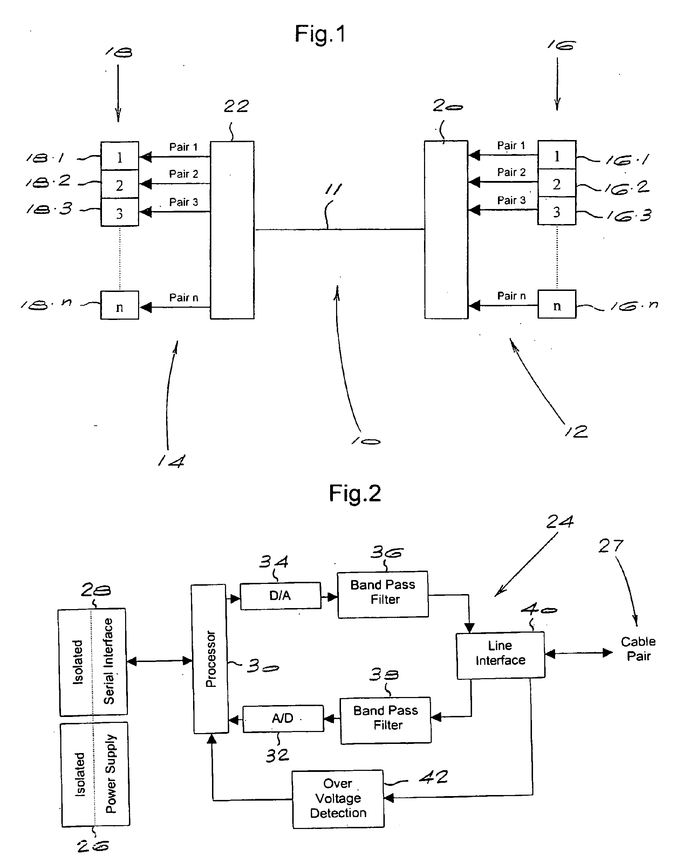

Referring first to Figure 1, a cable verification unit 10 is disclosed for tracing multi twisted copper pair cables, indicated generally by reference numeral 11, that extend between a remote cable site 12, such as a Street Distribution Cabinet (SDC), and a local cable site 14, such as a first Distribution Point (DP). The unit 10 comprises a bank 16 of transmitters 16.1 to 16.n, and a bank 18 of receivers 18.1 to 18.n. in particular, the cables 11 extend between remote and local cable termination blocks 20 and 22, respectively.

The bank 16 of transmitters located at the remote site 12 is arranged to inject the cable pairs with tracing signals that are encoded with information regarding the cable pair into which the tracing signal is being injected. Tnus, transmitter 16.1 transmits a tracing signal down copper Pair 1, transmitter 16.2 transmits a tracing signal down copper Pair 2 etc.

The bank 18 of receivers located at the local site 14 is arranged to receive and decode the tracing signal on the at least one cable. Thus, receiver 18.1 receives and decodes a tracing signal on copper Pair 1, receiver 18.2 receives and decodes a tracing signal on copper Pair 2 etc. In so doing, a comparison can be made between the decoded cable information from the tracing signal and the cable on which the tracing signal was received, to enable an end-to-end cable route to be determined.

Turning now to Figure 2, in the preferred version of the invention, the receiver and transmitter circuits are combined into a single transceiver unit 24. Thus, in use, two identical transceiver units are used: one at the local cable site 14 and one at the remote cable site 12.

Each transceiver unit 24 comprises an isolated power supply 26, thereby ensuring that each transceiver unit 24 in the bank 16, 18 is electrically isolated from each other. This arrangement also ensures that each of the cable pairs will stay isolated from each other when the bank of transceivers is connected to one end of a cable pair 27. To maintain isolation between each transceiver unit and the rest of the system, communication to and from the transceiver unit 24 is performed over an isolated serial interface 28.

The transceiver unit 24 further comprises a processor 30, which interfaces between the transceiver unit 24 and the rest of the system. The processor 30 builds the necessary frame structures, which will be discussed in more detail further on in the specification. The processor further performs the necessary Differential Phase Shift Keying (DPSK) modulation, but it should be noted that the modulation techniques are neither exclusive nor limited to DPSK modulation, and that other modulation techniques can also be used. The processor 30 is also responsible for demodulating received signals and for then reconstructing the frame structure. The processor 30 is further arranged to disconnect the unit 24 from the cable pair 27 if a hazardous voltage is detected on the cable pair 27.

An analogue to digital (A/D) converter 32 and a corresponding digital to analogue (D/A) converter 34 are also provided. The D/A converter 34 is used to convert digitally generated transmit waveforms into an analogue waveform. Conversely, the A/D converter 32 is used to convert analogue signals into digital values, to allow the processor to perform demodulation, and to limit the received signal so as to make it independent of the received signal level.

A pair of band pass filters 36 and 38 is provided, each one serving different purposes, depending on what mode the transceiver 24 is being used in. In the transmit mode or path, the band pass filter 36 filters out any spurious signals generated by the digital to analogue conversion process. In the receive mode or path the band pass filter 38 filters out the required signal and rejects all other signals that might be present on the cable pair 27. This advantageously improves the received signal to noise ratio.

The transceiver unit 24 is also provided with a line interface module 40, which is used to connect/disconnect the transceiver unit 24 to the cable pair 27, create a high impedance interface to the cable pair 27, and to provide surge and over voltage protection. Finally, the transceiver unit 24 also includes an Over Voltage Detection unit 42 for detecting hazardous voltages on the cable pair 27 that might damage the transceiver unit 24, and for then signaling this condition to the processor 30.

Two-way communication between the remote and local sites 12, 14 can be established after a cable pair has been traced. Thus, there are two important aspects of the present invention, namely the tracing aspect for tracing a copper pair of cable 11 between cable termination blocks 20 and 22 to determine which of Pairs 1 to n on blocks 20 and 22 correspond to each other, and the communication/command aspect in which command signals are sent between the blocks 20 and 22 to, for example, measure the characteristics of the traced cable pair. This communication/command feature of the present invention is particularly useful to test unused cable pairs for their integrity/usability, and to update the records of the telephone network operator accordingly.

During tracing, a Trace Frame structure is sent from the remote site 12 to the local site 14. During communication between the remote and local sites 12, 14, a Command Frame structure is used. The trace and command signals both have the following characteristics:

| | |
|---|---|
| Transmission method: | Half Duplex |
| Number of bits per frame: | 40 |
| Modulation: | Differential Phase Shift Keying (DPSK) |
| Transmission Speed: | 38.095 bits/s |
| Carrier Frequency: | 114.3 Hz |
| Time to transmit frame: | 1.05 s |
| Open circuit transmission level: | 1.8 Vrms nominally |
| Source and terminating impedance: | approximately 1 kΩ at 114 Hz and increase out of band |

The Command Frame structure is as follows:

| **Synchronization** | **Frame Alignment** | **Frame Type** | **Command** | **Parameter** | **CRC** |
|---|---|---|---|---|---|
| 8 bits | 8 bits | 1 bit | 7 bits | 8 bits | 8 bits |
| 10101010 | 01111110 | 1 | Xxxxxx | xxxxxxxxxx | xxxxxxxx |

The Trace Frame structure is as follows:

| **Synchronization** | **Frame Alignment** | **Frame Type** | **Synchronization** | **Pair Number** | **CRC** |
|---|---|---|---|---|---|
| 8 bits | 8 bits | 1 bit | 7 bits | 8 bits | 8 bits |
| 10101010 | 01111110 | 0 | 1010101 | xxxxxxxxxx | xxxxxxxx |

### Synchronization field

The synchronization field is used to synchronize the receiver to the incoming data bit stream. The value will always be binary "10101010" (0xAA). In the tracer frame structure an additional 7-bit synchronization field is added.

### Frame Alignment field

This field signals the start of a frame. The value will always be binary "01111110" (0x7E).

### Command field

This field is used to determine command or trace type frame structure between the local and remote unit, as discussed above.

### Parameter field

This field provides the parameter of the command.

### Pair Number

This field takes the form of a numerical value between 0 and 255, representing the pair number to which the tracer transceiver is connected.

### CRC field

This field is used for error checking, and is the 8-bit result of the CRC algorithm calculated for all the bits between the Frame Alignment field and the CRC field.

Conveniently, the tracing signal is non-intrusive so that voice and data services being carried on the cables during the tracing are not interrupted. This is achieved by using a low frequency narrow band tracing signal. The source and terminating impedance of the bank 16 of transmitters and bank 18 of receivers, as mentioned above, is also much higher than the characteristic impedances of the technologies/services being used over the copper pairs.

## Claims

1. A cable verification transceiver (24) for tracing telecommunications cables that extend between a remote site (12) and a local site (14) so as to enable an end to end cable route to be determined, the transceiver having a transmit mode and a receive mode and further comprising:
a plurality of transmitters (16);
a plurality of receivers (18); and
a processor (30) for, in the transmit mode, constructing a plurality of tracing signals that are each encoded with information regarding a cable pair (27) into which the tracing signal is to be transmitted by one of the plurality of transmitters, and for, in the receive mode, decoding a plurality of incoming tracing signals received from a plurality of cables via the plurality of receivers so that the transceiver is connectable to either the remote site, in which case the transceiver is acting in the transmit mode, or the local site, in which case the transceiver is acting in the receive mode.

2. A cable verification transceiver (24) according to claim 1, wherein a telecommunications cable comprises at least one twisted copper pair.

3. A cable verification transceiver (24) according to claim 1 or claim 2, which further includes a digital to analogue converter (34) for use in the transmit mode, and an analogue to digital converter (32) for use in the receive mode.

4. A cable verification transceiver according to any preceding claim, which further includes a first band pass filter (36) for use in the transmit mode, and a second band pass filter (38) for use in the receive mode.

5. A cable verification transceiver according to any preceding claim wherein the tracing signal comprises a frame structure comprising a pair number field that takes the form of a numerical value that represents the pair number to which the transceiver is connected.

## Patentansprüche

1. Kabelüberprüfungssendeempfänger (24) zum Überwachen von Telekommunikationskabeln, die sich zwischen einem entfernt liegenden Standort (12) und einem lokalen Standort (14) erstrecken, um das Bestimmen einer durchgehenden Kabelführung zu ermöglichen, wobei der Sendeempfänger einen Übertragungsmodus und einen Empfangsmodus aufweist und ferner umfasst:
mehrere Sender (16),
mehrere Empfänger (18) und
einen Prozessor (30), um im Sendemodus mehrere Überwachungssignale zu erstellen, die alle mit Informationen bezüglich eines Kabelpaars (27) codiert sind, in welches das Überwachungssignal durch einen von den mehreren Sendern zu senden ist, und um im Empfangsmodus mehrere ankommende Überwachungssignale zu decodieren, die aus mehreren Kabeln über die mehreren Empfänger empfangen werden, so dass der Sendeempfänger entweder an den entfernt liegenden Standort angeschlossen werden kann, wobei der Sendeempfänger in diesem Fall im Sendemodus arbeitet, oder an den lokalen Standort angeschlossen werden kann, wobei der Sendeempfänger in diesem Fall im Empfangsmodus arbeitet.

2. Kabelüberwachungssendeempfänger (24) nach Anspruch 1, wobei ein Telekommunikationskabel mindestens eine verdrillte Kupferdoppelleitung umfasst.

3. Kabelüberwachungssendeempfänger (24) nach Anspruch 1 oder Anspruch 2, der ferner einen Digital-AnalogWandler (34) zur Verwendung im Sendemodus und einen Analog-Digital-Wandler (32) zur Verwendung im Empfangsmodus umfasst.

4. Kabelüberwachungssendeempfänger nach einem der vorhergehenden Ansprüche, der ferner ein erstes Bandpassfilter (36) zur Verwendung im Sendemodus und ein zweites Bandpassfilter (38) zur Verwendung im Empfangsmodus umfasst.

5. Kabelüberwachungssendeempfänger nach einem der vorhergehenden Ansprüche, wobei das Überwachungssignal eine Rahmenstruktur umfasst, die ein Paarzahlenfeld enthält, das die Form eines numerischen Wertes annimmt, welcher die Paarzahl verkörpert, an welche der Sendeempfänger angeschlossen ist.

## Revendications

1. Emetteur-récepteur de vérification de câble (24) pour suivre des câbles de télécommunications qui s'étendent entre un site distant (12) et un site local (14) afin de permettre qu'un trajet de câble de bout en bout soit déterminé, l'émetteur-récepteur ayant un mode émission et un mode réception et comprenant en outre :
une pluralité d'émetteurs (16) ;
une pluralité de récepteurs (18) ; et
un processeur (30) pour, en mode émission, construire une pluralité de signaux de suivi qui sont chacun codés avec des informations concernant une paire en câble (27) dans laquelle le signal de suivi doit être transmis par un de la pluralité d'émetteurs, et pour, en mode réception, décoder une pluralité de signaux de suivi entrants reçus d'une pluralité de câbles via la pluralité de récepteurs de sorte que l'émetteur-récepteur puisse être connecté soit au site distant, auquel cas l'émetteur-récepteur fonctionne en mode émission, soit au site local, auquel cas l'émetteur-récepteur fonctionne en mode réception.

2. Emetteur-récepteur de vérification de câble (24) selon la revendication 1, dans lequel un câble de télécommunications comprend au moins une paire torsadée en cuivre.

3. Emetteur-récepteur de vérification de câble (24) selon la revendication 1 ou la revendication 2, qui inclut en outre un convertisseur numérique-analogique (34) pour une utilisation en mode émission, et un convertisseur analogique-numérique (32) pour une utilisation en mode réception.

4. Emetteur-récepteur de vérification de câble selon l'une quelconque des revendications précédentes, qui inclut en outre un premier filtre passe-bande (36) pour une utilisation en mode émission, et un second filtre passe-bande (38) pour une utilisation en mode réception.

5. Emetteur-récepteur de vérification de câble selon l'une quelconque des revendications précédentes, dans lequel le signal de suivi comprend une structure de trame comprenant un champ de numéro de paire qui prend la forme d'une valeur numérique qui représente le numéro de paire auquel l'émetteur-récepteur est connecté.
